# EUROPÄISCHE PATENTANMELDUNG

(11) **EP 1 189 494 A2**
(43) Veröffentlichungstag der Anmeldung: **20.03.2002**
(21) Anmeldenummer: 01118390.2
(22) Anmeldetag: 28.07.2001
(51) Int. Cl.: H05K 1/00, H01B 7/08

(54) **Umlenkvorrichtung für eine Flachbandleitung**

(30) Priorität: 15.09.2000 DE 10045765
(71) Anmelder: LEONI Bordnetz-Systeme GmbH & Co KG, 90402 Nürnberg (DE)
(72) Erfinder: Steinhauer, Thomas, 97447 Gerolzhofen (DE)
(74) Vertreter: Tergau & Pohl Patentanwälte

(57) **Zusammenfassung**

Die Umlenkvorrichtung (2A-D) insbesondere für einen Folienleiter (4) weist eine Grundklappe (10), eine Umlenkklappe (12) mit einer Umlenkkante (24) sowie eine Schutzklappe (14) auf. Im Montageendzustand ist der Folienleiter (4) zwischen der Grundklappe (10) und der Umlenkklappe (12) einerseits und andererseits zwischen der Umlenkkante (24) und der Schutzklappe (14) eingeklemmt. Über die Umlenkkante (24) ist er dabei beispielsweise um 90° umgelenkt. Die Umlenkvorrichtung (2A-D) ermöglicht ein Umlenken des Folienleiters (4), ohne dass im Umlenkbereich (26) unerwünscht hohe mechanische Belastungen auftreten. Die Schutzklappe (14) dient dabei insbesondere zum mechanischen Schutz des Folienleiters (4).

## Beschreibung

Die Erfindung betrifft eine Umlenkvorrichtung für eine Flachbandleitung, insbesondere für einen Folienleiter.

Die Flachbandleitung sowie der Folienleiter zeichnen sich durch ihre flache Bauweise aus und benötigen daher nur eine geringe Einbautiefe. Beim Folienleiter sind üblicherweise auf einer Trägerschicht eine Anzahl von Leiterbahnen aufgedampft. Das spezielle Herstellungsverfahren ermöglicht komplexe Leiterbahnmuster. Derartige Folienleiter werden insbesondere im Kfz-Bereich zur elektrischen Versorgung von Verbrauchern mit mäßigem Stromverbrauch eingesetzt, wie beispielsweise zur Versorgung von Steuereinheiten, Lautsprechern oder einer Innenbeleuchtung.

Aufgrund der flächenhaften Ausdehnung des Folienleiters ist er im Wesentlichen nur zur geradlinigen Verlegung geeignet. Eine Richtungsänderung des Folienleiters in der Ebene seiner flächenhaften Ausdehnung ist problematisch. Insbesondere besteht bei einer starken Umlenkung die Gefahr, dass im Umlenkbereich die einzelnen Leiterbahnen geknickt werden, oder der Folienleiter einer zu hohen mechanischen Belastung ausgesetzt ist.

In der EP 0 454 272 A1 ist eine Haltevorrichtung für eine Flachbandleitung beschrieben, mit deren Hilfe ein Folienleitungsmuster, bestehend aus mehreren Folienleitungsabschnitten, in einer aufgefalteten Position gehalten werden soll. Bei der Haltevorrichtung sind zwei über eine Trennwand getrennte Teilräume zwischen Außenwänden eingeschlossen. Die Trennwand weist eine erste Biegekante auf, um die die Folienleitung herumgeschlagen ist. Die eine Außenwand weist randseitig eine weitere, rechtwinklig zur ersten Biegekante angeordnete zweite Biegekante auf, um die die Folienleitung ein zweites Mal umgebogen ist. Die Haltevorrichtung als Ganzes ist nach Art eines Gehäuses ausgebildet, in das die Folienleitung eingeschoben werden muss. Hierzu ist es erforderlich, die Folienleitung bereits vor dem Einschieben in die Haltevorrichtung an den gewünschten Stellen zu falten. Dies ist zum einen aufwändig und zum anderen besteht die Gefahr, dass die Faltungsstellen nicht genau an der gewünschten Stelle ausgebildet sind bzw. dass sie nicht exakt an den Biegekanten anliegen, wodurch die Folienleitung höheren Belastungen als notwendig ausgesetzt sein kann.

Der Erfindung liegt die Aufgabe zugrunde, eine einfache und sichere Verlegung eines Flachbandkabels, insbesondere eines Folienleiters, zu ermöglichen.

Die Aufgabe wird gemäß der Erfindung gelöst durch eine Umlenkvorrichtung für eine Flachbandleitung, insbesondere für einen Folienleiter, wobei die Umlenkvorrichtung eine Grundklappe, eine Umlenkklappe mit einer Umlenkkante sowie eine Schutzklappe aufweist. Die Klappen sind dabei derart schwenkbar miteinander verbunden, dass im Montageendzustand bei eingelegter Flachbandleitung zwischen der Grundklappe und der Umlenkklappe ein Führungsbereich gebildet ist, in dem die Flachbandleitung geführt ist und der sich bis zu einem zwischen der Umlenkkante und der Schutzklappe gebildeten Umlenkbereich erstreckt, in dem die Flachbandleitung umgelenkt ist.

Zum Umlenken des Folienleiters wird dieser vorzugsweise zunächst auf die Grundklappe gelegt und durch Verbinden der Grundklappe mit der Umlenkklappe im Führungsbereich gehalten. Anschließend wird der Folienleiter um die an der Umlenkklappe angeordnete Umlenkkante gebogen und in dieser umgelenkten Stellung zwischen der Umlenkkante und der Schutzklappe gehalten.

Diese Umlenkvorrichtung ermöglicht daher ein schonendes Umlenken des Folienleiters in der Ebene seiner flächenhaften Ausdehnung. Hierzu wird der Folienleiter einerseits durch die Umlenkvorrichtung definiert hindurchgeführt. Durch das definierte Umbiegen des Folienleiters im Biege- oder Umlenkbereich wird eine übermäßige mechanische Belastung vermieden. Bevorzugt wird der Folienleiter hierbei im Führungsbereich und im Umlenkbereich zwischen den jeweiligen Klappen eingeklemmt. Zum schonenden Umlenken wird andererseits der Folienleiter im Umlenkbereich vor einer mechanischen Beschädigung von außen durch die Schutzklappe geschützt. Insbesondere dient die Schutzklappe als Reibschutz.

Die Umlenkvorrichtung besteht vorzugsweise aus einer einzigen und als Spritzgussteil ausgebildeten Baueinheit, bei der die einzelnen Klappen beispielsweise über Filmscharniere miteinander verbunden sind. Die Ausbildung als einheitliches Bauteil mit mehreren scharnierartig miteinander verbundenen Klappen erleichtert das Einlegen des Folienleiters in die Umlenkvorrichtung, da nicht mehrere separate Bauteile miteinander verbunden werden müssen bzw. da ein umständliches Einfädeln des Folienleiters nicht notwendig ist.

Um die Belastung des Folienleiters im Bereich der Umlenkkante gering zu halten, weist diese vorzugsweise einen gerundeten Querschnitt auf. Ein scharfes Abknikken des Folienleiters ist damit verhindert.

Vorzugsweise weisen die Umlenkklappe und die Grundklappe jeweils eine Flächenausdehnung mit zwei jeweils einander gegenüberliegenden Grundseiten und Stirnseiten auf, wobei die Grundklappe und die Umlenkklappe an einer ihrer Grundseiten miteinander verbunden sind. Bei dieser Ausgestaltung ist also ein seitliches Aufklappen der Grundklappe und der Umlenkklappe ermöglicht. Der Folienleiter wird dabei bevorzugt parallel zu den Grundseiten durch die Umlenkvorrichtung geführt.

Zweckdienlicherweise ist für eine Querfaltung des Folienleiters an einer der Stirnseiten der Umlenkklappe die Umlenkkante vorgesehen. Zugleich ist durch den zwischen einer der Grundseiten und dieser Umlenkkante eingeschlossenen Winkel ein Umlenkwinkel für die Flachbandleitung festgelegt. Unter Querfaltung oder Querumlenkung wird hierbei eine Umlenkung des Folienleiters unter einem Winkel zu seiner Längsrichtung verstanden. Der Folienleiter ist demnach im Montageendzustand an einer Stirnseite der Umlenkvorrichtung um die Umlenkkante gelegt. Da der Umlenkwinkel durch die Winkelbeziehung zwischen der Grundseite und der Stirnseite festgelegt ist, sind unterschiedliche Umlenkvorrichtungen mit nahezu beliebigen Umlenkwinkeln herstellbar. Insbesondere ist durch eine geeignete Ausgestaltung der Umlenkvorrichtung eine 90°- oder auch eine 180°-Umlenkung des Folienleiters ermöglicht. Für eine möglichst einfache und symmetrische Ausbildung sind die Grundklappe und die Umlenkklappe mit einer übereinstimmenden Grundfläche ausgebildet, so dass die beiden Klappen im Montageendzustand passgenau übereinander liegen. Die Grundfläche definiert dabei im Wesentlichen den Führungsbereich. Sie ist vorzugsweise als Parallelogramm ausgebildet.

Vorzugsweise ist die Schutzklappe an der der Umlenkklappe zugeordneten Stirnseite der Grundplatte angeordnet. Zum Einklemmen des Folienleiters im Umlenkbereich wird die Schutzklappe von der Grundplatte einfach in Richtung auf die Umlenkklappe zu geschwenkt.

Gemäß einer bevorzugten Ausgestaltung ist alternativ die Umlenkkante an der der Grundklappe abgewandten Grundseite der Umlenkklappe angeordnet. Hierdurch ist eine Längsfaltung der Flachbandleitung möglich, also eine Faltung in ihrer Längsrichtung. Vom Prinzip her erfolgt diese Längsfaltung ähnlich wie die Querfaltung. Lediglich die Umlenkklappe und zweckdienlicherweise auch die zugehörige Schutzklappe sind an den parallel zur Längsrichtung des Folienleiters verlaufenden Grundseiten der Umlenkklappe bzw. der Grundklappe angeordnet. Die Umlenkklappe und die Grundklappe sind dabei weiterhin an einer ihrer Grundseiten miteinander schwenkbar verbunden, um den Folienleiter an den Stirnseiten ein- bzw. ausführen zu können.

Die Längsfaltung des Folienleiters ist bei der Verwendung eines mehrreihigen Anschlusssteckers von großem Vorteil. Ein solcher mehrreihiger Anschlussstecker zeichnet sich durch zumindest zwei übereinander angeordneten Ebenen aus, in denen Anschlussmöglichkeiten bereitgestellt werden. Dadurch besteht die Möglichkeit, die eine Hälfte der Leiterbahnen des Folienleiters beispielsweise in die obere Anschlussebene und die zweite Hälfte in die untere Anschlussebene zu führen. Der mehrreihige Anschlussstecker ist dadurch schmal ausgeführt. Der Folienleiter wird dem Anschlussstecker quasi doppellagig in zwei Teilbahnen zugeführt. Die Umlenkvorrichtung dient hierbei also zum Aufteilen des Folienleiters von einer Leiterebene in zwei Leiterebenen.

Vorzugsweise ist dabei in der Montageendposition zwischen der Schutzklappe und der Umlenkklappe ein weiterer Führungsbereich für den Folienleiter gebildet. Der Folienleiter wird also doppellagig durch die Umlenkvorrichtung geführt, wobei die einzelnen Klappen schichtweise übereinander angeordnet sind und zwischen zwei benachbarten Klappen jeweils eine Teilbahn des Folienleiters geführt ist. Zweckdienlicherweise haben dabei die einzelnen Klappen die gleiche Grundfläche.

Gemäß einer weiteren vorteilhaften Ausgestaltung ist die Umlenkvorrichtung sowohl zur Längs- als auch zur Querfaltung ausgebildet. Hierzu weist die Umlenkvorrichtung zusätzlich zur Umlenkkante für die Längsfaltung eine weitere Umlenkkante für die Querfaltung auf. Diese ist dabei bevorzugt mit einer der Stirnseiten der Schutzklappe verbunden.

Zum Schutz der zusätzlichen Querfaltung des Folienleiters ist eine weitere Schutzklappe vorgesehen, die mit der weiteren Umlenkkante zusammenwirkt. Insbesondere ist die Schutzklappe mit einer der Stirnseiten der Grundklappe verbunden. In dieser kombinierten Ausgestaltung für die Längs- und Querfaltung sind demnach die Gestaltungsmerkmale für die Ausbildung zur Längsfaltung und die für die Querfaltung miteinander kombiniert.

Um ein einfaches und sicheres Einlegen des Folienleiters in die Umlenkvorrichtung zu ermöglichen, ist im Führungsbereich ein Fixierelement zum Fixieren des Folienleiters vorgesehen. Ein Verrutschen des Folienleiters in der Umlenkvorrichtung, insbesondere beim Einlegen des Folienleiters, ist dadurch vermieden.

Ebenfalls zur Montageerleichterung ist bevorzugt an einer dem Führungsbereich abgewandten Montageoberseite ein Halteelement für den umgebogenen Teil des Folienleiters vorgesehen. Dieses Halteelement dient dazu, den Folienleiter, bevor er zwischen der Umlenkkante und der Schutzklappe eingeklemmt wird, bereits in der umgelenkten Stellung zu halten.

Zweckdienlicherweise sind zumindest einige der Klappen im Montageendzustand miteinander fest verbunden, insbesondere sind sie fest miteinander verrastet. Dadurch ist ein sicheres definiertes Umlenken des Folienleiters erreicht.

Für eine einfache Montage der Umlenkvorrichtung ist an einer Montageunterseite ein Befestigungselement zur Befestigung beispielsweise an einem Karosseriebauteil eines Kraftfahrzeugs vorgesehen. Zusätzlich zu dem Befestigungselement kann ein weiteres Element zum Verdrehschutz vorgesehen sein.

In einer bevorzugten Ausbildung weist die Umlenkvorrichtung an ihrer Montageoberseite ein Koppelelement zur Anordnung einer weiteren Umlenkvorrichtung auf. Dieses Koppelelement ist dabei beispielsweise komplementär zu dem Befestigungselement an der Montageunterseite ausgebildet, so dass zwei Umlenkvorrichtungen über das Koppelelement und das Befestigungselement stapelartig miteinander verbunden werden können.

Ausführungsbeispiele der Erfindung werden im Folgenden anhand der Zeichnung näher erläutert. Es zeigen jeweils in schematischen Darstellungen:
- Fig. 1: eine Umlenkvorrichtung zur Querfaltung eines Folienleiters im Montageendzustand mit eingelegtem Folienleiter für eine 90°-Umlenkung in einer Aufsicht,
- Fig. 2: die Umlenkvorrichtung nach Fig. 1 in einer Zwischenmontagestellung,
- Fig. 3: eine Umlenkvorrichtung zur Querfaltung eines Folienleiters im Montageendzustand mit eingelegtem Folienleiter für eine 180°-Umlenkung in einer perspektivischen Ansicht,
- Fig. 4: die Umlenkvorrichtung nach Fig. 3 in einer aufgeklappten Ausgangsstellung,
- Fig. 5: die Umlenkvorrichtung nach Fig. 3 im Montageendzustand in einer Seitenansicht,
- Fig. 6: eine Umlenkvorrichtung zur Längsfaltung eines Folienleiters im Montageendzustand mit eingelegtem Folienleiter in einer perspektivischen Ansicht,
- Fig. 7: einen mäanderförmig ausgebildeten Folienleiter,
- Fig. 8: eine Umlenkvorrichtung zur gleichzeitigen Längs- und Querfaltung eines Folienleiters in einer Montageendposition mit eingelegtem Folienleiter in einer perspektivischen Ansicht,
- Fig. 9: die Umlenkvorrichtung nach Fig. 8 in einer Zwischenmontageposition und
- Fig. 10: die Umlenkvorrichtung nach Fig. 8 im aufgeklappten Zustand ohne Folienleiter.

In den einzelnen Figuren sind gleich wirkende Elemente mit den gleichen Bezugszeichen versehen.

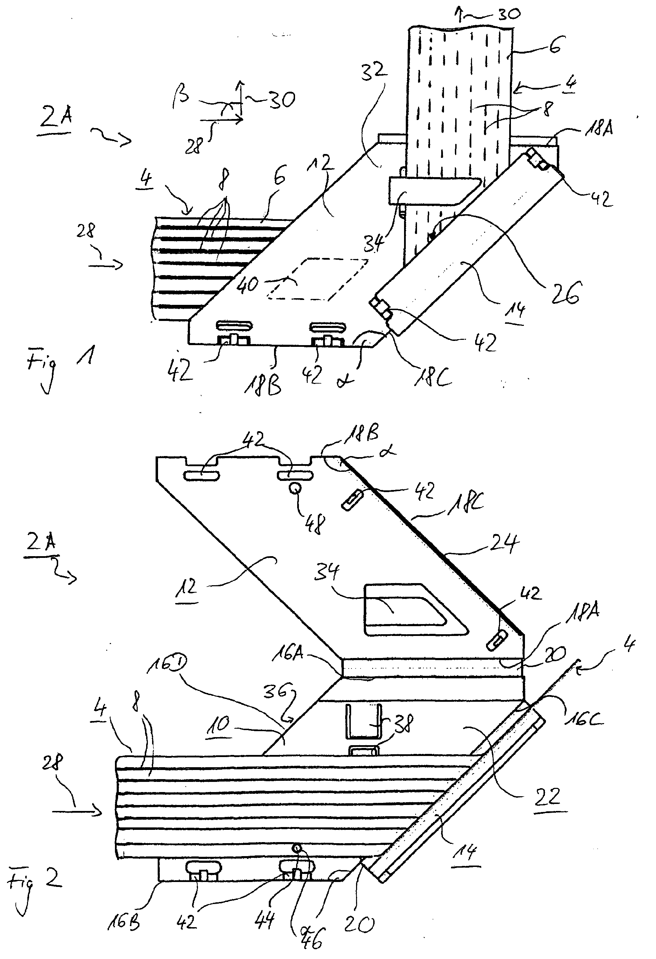

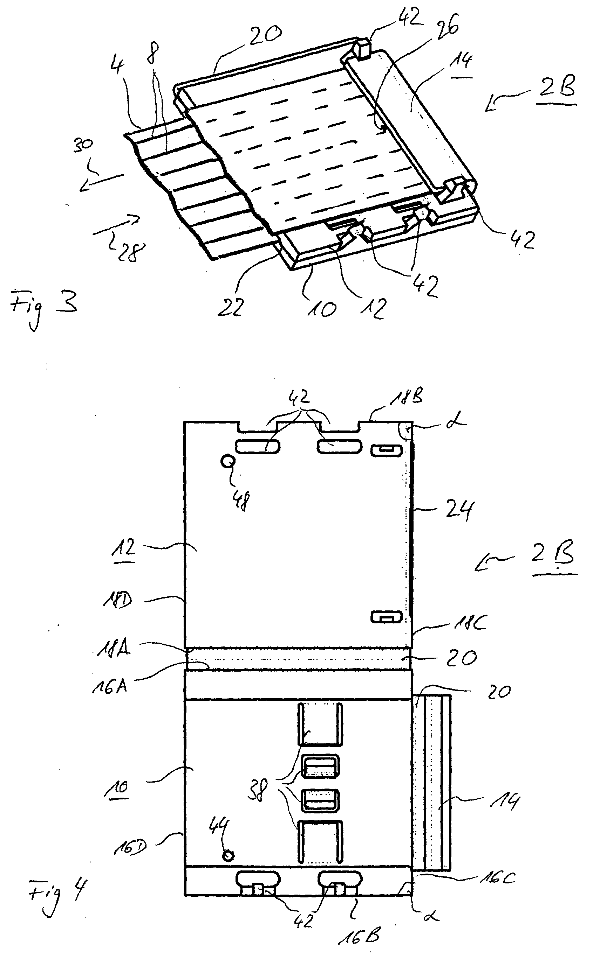

Eine erste Ausgestaltung einer Umlenkvorrichtung 2A für einen Folienleiter 4 gemäß den Fig. 1 und 2 dient zur Querfaltung oder Querumlenkung des Folienleiters 4 um 90°. Der Folienleiter 4 weist mehrere auf der Oberseite einer Trägerschicht 6 aufgebrachte Leiterbahnen 8 auf. Diese sind als durchgezogene Linien dargestellt, sofern die Blickrichtung auf die Oberseite der Trägerschicht ist. Sie sind als gestrichelte Linien dargestellt, sofern die Blickrichtung von der Unterseite auf die Trägerschicht 6 ist.

Die Umlenkvorrichtung 2 weist eine Grundklappe 10, eine Umlenkklappe 12 sowie eine Schutzklappe 14 auf. Die Grundklappe 10 und die Umlenkklappe 12 weisen jeweils nach Art eines Parallelogramms ausgebildete Grundflächen auf, die von jeweils parallel zueinander verlaufenden Grundseiten 16A,B bzw. 18A,B begrenzt sind. Die Grundseiten 16A,B;18A,B sind jeweils mit ebenfalls parallel zueinander verlaufenden Stirnseiten 16C,D bzw. 18C,D verbunden.

Die Umlenkklappe 12 und die Grundklappe 10 sind an ihren Grundseiten 16A,18A über ein Filmscharnier 20 schwenkbeweglich miteinander verbunden. Die Schutzklappe 14 ist an der Stirnseite 16C der Grundklappe 10 ebenfalls über ein Filmscharnier 20 schwenkbeweglich angeordnet.

Zwischen der Grundklappe 10 und der Umlenkklappe 12 ist der Folienleiter 4 in einem Führungsbereich 22 eingeklemmt. Die Umlenkklappe 12 weist an ihrer einen Stirnseite 18C eine Umlenkkante 24 auf. Im Montageendzustand ist der Folienleiter 4 um diese Umlenkkante 24 umgelenkt. Zwischen der Umlenkkante 24 und der Schutzklappe 14 wird dabei ein Umlenkbereich 26 definiert, in dem der Folienleiter 4 im Montageendzustand ebenfalls eingeklemmt ist.

Die Grundseite 16B und die Stirnseite 16C der Grundklappe 10 sowie die korrespondierende Grundseite 18B und die korrespondierende Stirnseite 18C der Umlenkklappe 12 schließen jeweils einen Winkel α ein. Da die Umlenkkante 24 parallel zur Stirnseite 18C verläuft und der Folienleiter 4 mit seiner Eingangslängsrichtung 28 parallel zur Grundseite 18B eingelegt wird, ist über den Winkel α ein Umlenkwinkel β für den Folienleiter 4 definiert. Dieser Umlenkwinkel β bezeichnet den Winkel zwischen der Eingangslängsrichtung 28 und einer Ausgangslängsrichtung 30 des Folienleiters. Bei der Ausführungsvariante nach den Fig. 1 und 2 beträgt der Winkel α 135°, so dass ein Umlenkwinkel β von 90° gebildet ist. In Abhängigkeit der Ausbildung des Winkel α können beliebige Umlenkwinkel β verwirklicht werden.

Die Umlenkvorrichtung 2A weist auf ihrer Montageoberseite 32, also auf der dem Führungsbereich 22 abgewandten Außenseite der Umlenkklappe 12, ein Halteelement 34 auf. Das Halteelement 34 ist dabei nach Art eines Bügels ausgebildet, unter dem der Folienleiter 4 hindurchgeführt ist.

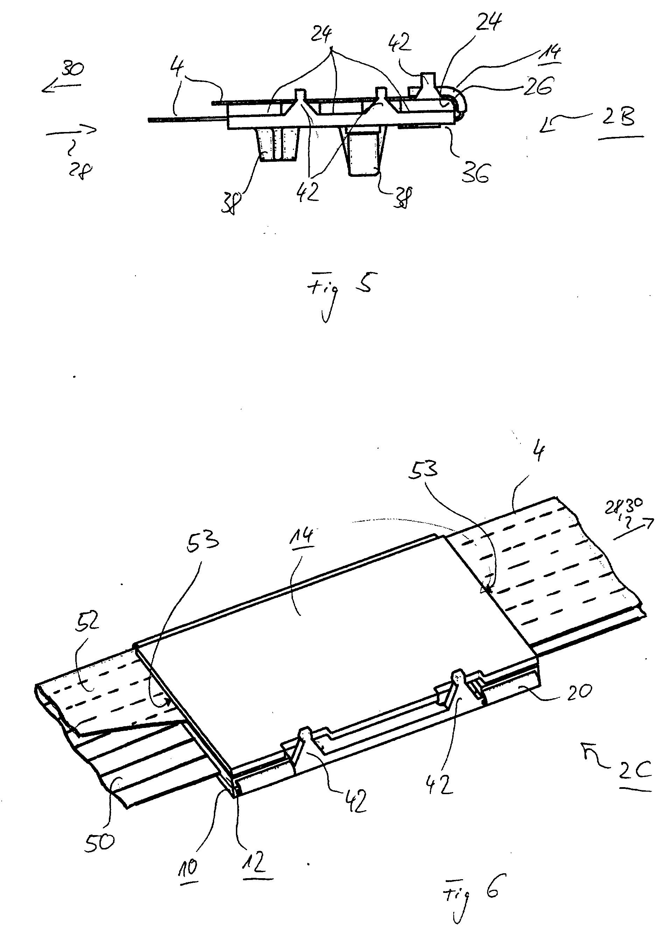

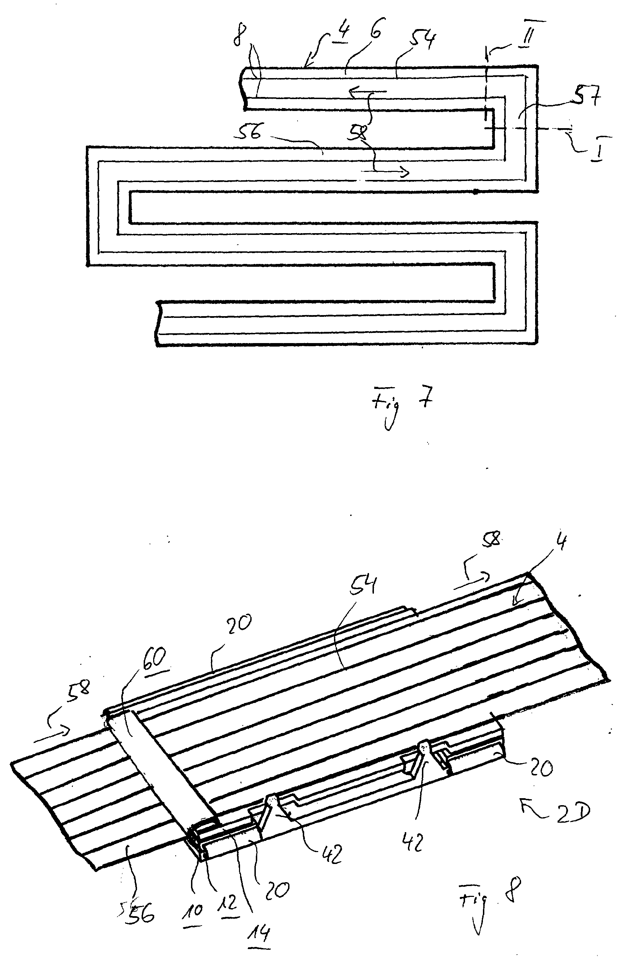

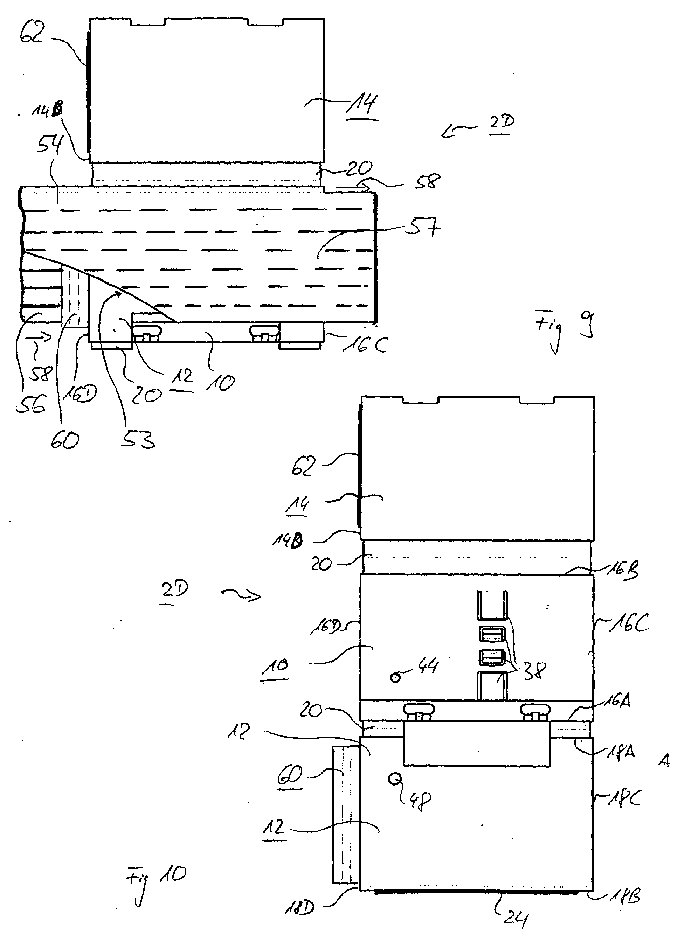

An einer Montageunterseite 36, die definiert ist durch die dem Führungsbereich 22 abgewandten Außenseite der Grundklappe 10, sind Befestigungselemente 38 angeordnet (vgl. hierzu auch insbesondere die Fig. 5). Diese Befestigungselemente 38 dienen zur Befestigung der Umlenkvorrichtung 2A beispielsweise an einem Karosseriebauteil eines Kraftfahrzeugs. Auf der Montageoberseite 22 kann darüber hinaus ein Koppelelement 40 vorgesehen sein, das vorzugsweise zu dem Befestigungselement 38 komplementär ausgebildet ist. Über das Koppelelement und das Befestigungselement 38 können zwei Umlenkvorrichtungen 2A miteinander stapelweise verbunden werden. Das Koppelelement 40 ist in Fig. 1 lediglich schematisch durch eine gestrichelte Linie angedeutet.

Die einzelnen Klappen 10,12,14 weisen darüber hinaus mehrere Rastelemente 42 auf, die dazu dienen, dass die einzelnen Klappen 10,12,14 im Montageendzustand über Rastverbindungen fest miteinander verbunden sind.

Weiterhin sind im Führungsbereich 22 Fixierelemente zum Fixieren des Folienleiters 4 beim Einlegen in die Umlenkvorrichtung 2A angeordnet. Die Fixierelemente sind dabei gebildet durch einen an der Grundklappe 10 angebrachten Fixierstift 44, der durch eine entsprechende Fixierausnehmung 46 im Folienleiter 4 hindurchgreift und sich in einem Fixierloch 48 an der Umlenkklappe 12 abstützt.

Zum Umlenken des Folienleiters 4 mittels der Umlenkvorrichtung 2A wird folgendermaßen vorgegangen: Im aufgeklappten Zustand der Umlenkvorrichtung 2A, wie sie aus Fig. 2 zu entnehmen ist, wird der Folienleiter 4 auf die Grundklappe 10 aufgelegt und über die beiden Fixierelemente 44,46 unverrutschbar gehalten. Die Eingangslängsrichtung 28 ist dabei parallel zur Grundseite 16B ausgerichtet. Anschließend wird die Umlenkklappe 12 mit der Grundklappe 10 über die Rastelemente 42 verrastet und der Folienleiter 4 im Führungsbereich 22 eingeklemmt. Daraufhin wird der Folienleiter 4 entlang der Umlenkkante 24 umgebogen und unter das Halteelement 34 geheftet, so dass er in der umgelenkten Position über das Halteelement 34 provisorisch gehalten ist. Das Halteelement 34 erleichtert also das Einlegen des Folienleiters 4. Im letzten Schritt wird die Schutzklappe 14 an der Umlenkklappe 12 über die entsprechenden Rastelemente 42 verrastet, so dass der Folienleiter 4 zwischen der Umlenkklappe 24 und der Schutzklappe 24 im Umlenkbereich 26 eingeklemmt wird.

Der Umlenkbereich 26 des Folienleiters 4 ist durch die Schutzklappe 14 vor äußeren Einflüssen sicher geschützt. Zugleich ist durch die definierte Führung des Folienleiters 4 in der Umlenkvorrichtung 2A die mechanische Belastung des Folienleiters 4 gering gehalten. Hierzu ist insbesondere die Umlenkkante 24 gerundet ausgebildet. Die Umlenkvorrichtung 2A gewährleistet also, dass der Folienleiter 4 nicht scharfkantig umgeknickt wird.

Eine zweite Ausgestaltung einer Umlenkvorrichtung 2B zur 180°-Querumlenkung oder Querfaltung des Folienleiters 4 ist in den Fig. 3 bis 5 dargestellt. Die Umlenkvorrichtung 2B ist dabei ähnlich wie die Umlenkvorrichtung 2A gemäß Fig. 1 und 2 ausgebildet. Der wesentliche Unterschied ist in der veränderten Winkelanordnung der Grundseiten 16A,B bzw. 18,B zu den Stirnseiten 16C,D bzw. 18C,D zu sehen. Und zwar beträgt der Winkel α nunmehr 90°, so dass die Eingangslängsrichtung 28 entgegengesetzt zu der Ausgangslängsrichtung 30 verläuft. Die Umlenkvorrichtung 2B dient also zur 180°-Umlenkung des Folienleiters 4.

Anhand Fig. 5 ist zu entnehmen, dass an der Montageunterseite 36 zwei Befestigungselemente 38 vorgesehen sind, wobei das eine beispielsweise als Rastelement zur Verrastung und das andere als Verdrehschutz mit im Querschnitt gesehen kreuzförmigem Profil ausgebildet ist.

Weiterhin ist Fig. 5 zu entnehmen, dass die Schutzklappe 14 im Querschnitt gesehen etwa als ein liegendes J, also gerundet, ausgebildet ist. Die Krümmung der Schutzklappe 14 ist dabei im Wesentlichen an die Krümmung der gerundeten Umlenkkante 24 angepasst.

Eine dritte alternative Ausführungsform einer Umlenkvorrichtung 2C zur Längsumlenkung oder Längsfaltung des Folienleiters 4 ist Fig. 6 zu entnehmen. Der Folienleiter 4 wird bei dieser Längsfaltung in Längsrichtung 28 zusammengeklappt, so dass er zweilagig geführt wird. Bei dieser Umlenkvorrichtung 2C fallen die Eingangslängsrichtung 28 und die Ausgangslängsrichtung 30 demzufolge zusammen. Im Montageendzustand, wie er in Fig. 6 gezeigt ist, ist eine untere Teilbahn 50 des Folienleiters 4 zwischen der Grundklappe 10 und der Umlenkklappe 12 und eine obere Teilbahn 52 des Folienleiters 4 zwischen der Umlenkklappe 12 und der Schutzklappe 14 eingeklemmt. In dieser Ausgestaltung ist also zwischen der Umlenkklappe 12 und der Schutzklappe 14 ein weiterer Führungsbereich 53 gebildet. Der Folienleiter 4 ist daher mit seinen beiden Teilbahnen 50,52 sandwichartig zwischen den schichtweise angeordneten Klappen 10,12,14 eingeklemmt. Der Vorgang des Einlegens des Folienleiters 4 in die Umlenkvorrichtung 2C zur Längsfaltung wird im Zusammenhang mit einer in den Fig. 8 bis 10 dargestellten weiteren Ausführungsform erläutert.

Eine derartige Umlenkvorrichtung 2C zur Längsfaltung dient insbesondere zum Anschluss des Folienleiters 4 an einen mehrreihigen Anschlussstecker, also an einen Stecker, der über mehrere Etagen Anschlussmöglichkeiten aufweist (nicht dargestellt). Durch die Längsfaltung wird ermöglicht, dass die untere Teilbahn 50 in die untere Etage und die obere Teilbahn 52 des Folienleiters 4 in die obere Etage des mehrreihigen Anschlusssteckers geführt wird. Um die beiden Teilbahnen 50,52 für eine einfache Montage ausreichend weit voneinander beabstanden zu können ist der Folienleiter zumindest im Anschluss an die Umlenkvorrichtung 2C längsgeschlitzt, so dass die beiden Teilbahnen 50,52 als separate und voneinander getrennte Bahnen geführt werden können.

Eine weitere Ausführungsform einer Umlenkvorrichtung 2D gemäß den Fig. 8 bis 10 dient zur gleichzeitigen Längs- und Querumlenkung des Folienleiters 4. Die Umlenkvorrichtung 2D dient insbesondere zur Auffaltung oder Längsstreckung eines mäanderförmig verlaufenden Folienleiters 4, wie er beispielhaft in Fig. 7 dargestellt ist. Die mäanderförmige Ausgestaltung des Folienleiters 4 ist herstellungstechnisch bedingt. Und zwar wird zur Herstellung des Folienleiters auf einer Platte mit begrenzten Abmaßen die Trägerschicht 6 mit den Leiterbahnen 8 aufgebracht. Aufgrund der begrenzten Abmessungen der Platte ist eine quasi endlose Ausbildung des Folienleiters 4 nicht möglich. Er wird daher mäanderförmig ausgebildet, um den auf der Platte verfügbaren Platz optimal auszunutzen. Wird ein geradlinig verlaufender Folienleiter 4 mit einer vergleichsweise großen Länge benötigt, so wird der mäanderförmig verlaufende Folienleiter 4 in einfacher Weise mittels der Umlenkvorrichtung 2D "entfaltet", so dass ein einziger langgestreckter Folienleiter 4 gebildet ist. Diese Entfaltung erfolgt einerseits durch eine Längsfaltung entlang der gestrichelten Linie I sowie einer Querfaltung entlang der gestrichelten Linie II. Die Längsfaltung entlang der Linie I sorgt dabei dafür, dass eine erste Mäanderteilbahn 54 über eine zweite Mäanderteilbahn 56 zu liegen kommt. In diesem Zustand sind die Längsrichtungen 58 der beiden Mäanderteilbahnen 54,56 einander entgegen gerichtet. Die Querfaltung entlang der Linie II sorgt für eine Gleichrichtung der Längsrichtungen 58. Die beiden Mäanderteilbahnen 54,56 sind dabei über ein Zwischenstück 57 miteinander verbunden.

Der Entfaltungsvorgang mittels der Umlenkvorrichtung 2 wird im Folgenden anhand der Fig. 8 bis 10 erläutert. Dabei ist aus Fig. 10 zu entnehmen, dass die Umlenkvorrichtung 2D insgesamt vier Klappen umfasst, nämlich die Grundklappe 10, die Umlenkklappe 12, die Schutzklappe 14 und eine weitere Schutzklappe 60. Die Grundplatte 10 und die Umlenkklappe 12 sind - wie auch bei den Ausführungsformen zur Querumlenkung - an ihren aufeinander zugewandten Grundseiten 16A,18A über ein Filmscharnier 20 miteinander verbunden. Im Unterschied zu den Ausführungsformen zur Querfaltung ist die Schutzklappe 14 zur Längsfaltung an der zweiten Grundseite 16B der Grundklappe 10 über ein Filmscharnier 20 schwenkbar angeordnet. Dabei weisen diese drei Klappen 10,12,14 jeweils in etwa die gleiche Grundfläche auf.

Die rein für die Längsfaltung ausgebildete Umlenkvorrichtung 2C nach Fig. 6 entspricht dabei der Anordnung dieser drei Klappen 10,12,14 gemäß Fig. 10. Die zusätzliche Option der Querfaltung wird bei der Umlenkvorrichtung 2D gemäß Fig.10 durch die weitere Schutzklappe 60 und insbesondere durch eine weitere Umlenkkante 62 an einer Stirnseite 14D der Schutzklappe 14 ermöglicht.

Zur Längsfaltung wird der Folienleiter 4 wie auf die Grundklappe 10 gelegt. Und zwar wird die zweite Mäanderteilbahn 56 stirnseitig eingeführt, so dass das Zwischenstück 57 auf der Grundklappe 10 aufliegt und gegebenenfalls ein kleines Stück über die zweite Stirnseite 16C hinaus steht. Die Breite der Grundklappe 10 und damit in etwa die Breite der Umlenkvorrichtung 2D entspricht dabei in etwa der Breite einer Mäanderteilbahn 54,56, und im Falle der Fig. 6 der Breite der beiden Teilbahnen 50,52. Die zweite Teilbahn, also die obere Teilbahn 52 gemäß Fig. 6 oder die erste Mäanderteilbahn 54 gemäß Fig. 9, überlappt also die Grundklappe 10 über ihre Grundseite 16B hinweg. Im zweiten Verfahrensschritt wird die Umlenkklappe 12 um die Grundseite 16A der Grundklappe 10 geschwenkt und die zweite Mäanderteilbahn 56 mit einem Teil des Zwischenstücks 57 zwischen der Grundklappe 10 und der Umlenkklappe 12 eingeklemmt. Anschließend wird das Rest-Teilstück des Zwischenstücks 57 um die Umlenkkante 24 umgebogen und liegt auf der Oberseite der Umlenkklappe 12 auf. Diese Montagezwischenposition ist in Fig. 9 dargestellt. Im nächsten Schritt wird die Schutzklappe 14 um das Filmscharnier 20 geschwenkt, so dass die erste Mäanderteilbahn 54 mit dem Zwischenstück 57 zwischen der Schutzklappe 14 und der Umlenkklappe 12 im weiteren Führungsbereich 53 eingeklemmt wird. Die einzelnen Klappen 10,12,14 sind in dieser Position miteinander verrastet, so dass der Folienleiter 4 in der Umlenkvorrichtung 2C,D fest eingeklemmt ist, wie dies aus Fig. 6 zu entnehmen ist.

Zur Querfaltung wird nunmehr die erste Mäanderteilbahn 54 um die weitere Umlenkkante 62 an der Schutzklappe 14 umgebogen und mittels der weiteren Schutzklappe 60 in dieser umgelenkten Stellung eingeklemmt. Zur Montagevereinfachung kann ebenfalls wiederum ein Halteelement 34 vorgesehen sein, wie es den Fig. 1 und 2 zu entnehmen ist. Die weitere Schutzklappe 60 wird vorzugsweise ebenfalls mit der Schutzklappe 14 verrastet.

Im Montageendzustand, wie er in Fig. 8 dargestellt ist, ist der Folienleiter 4 also in insgesamt drei Ebenen von der Umlenkvorrichtung 2D sandwichartig eingeklemmt. Die erste Ebene liegt dabei zwischen der Grundklappe 10 und der Umlenkklappe 12, die zweite Ebene zwischen der Umlenkklappe 12 und der Schutzklappe 14 und die dritte Ebene zwischen der Schutzklappe 14 und der weiteren Schutzklappe 60.

### Bezugszeichenliste

- 2A,B,C,D: Umlenkvorrichtung
- 4: Folienleiter
- 6: Trägerschicht
- 8: Leiterbahn
- 10: Grundklappe
- 12: Umlenkklappe
- 14: Schutzklappe
- 14D: Stirnseite der Schutzklappe
- 16A,B: Grundseiten der Grundklappe
- 18A,B: Grundseiten der Umlenkklappe
- 16C,D: Stirnseiten der Grundklappe
- 18C,D: Stirnseiten der Umlenkklappe
- 20: Filmscharnier
- 22: Führungsbereich
- 24: Umlenkkante
- 26: Umlenkbereich
- 28: Eingangslängsrichtung
- 30: Ausgangslängsrichtung
- 32: Montageoberseite
- 34: Halteelement
- 36: Montageunterseite
- 38A,B: Befestigungselement
- 40: Koppelelement
- 42: Rastelement
- 44: Fixierstift
- 46: Fixierausnehmung
- 48: Fixierloch
- 50: untere Teilbahn
- 52: obere Teilbahn
- 53: weiterer Führungsbereich
- 54: erste Mäanderteilbahn
- 56: zweite Mäanderteilbahn
- 57: Zwischenstück
- 58: Längsrichtung
- 60: weitere Schutzklappe
- 62: weitere Umlenkkante

- α: Winkel
- β: Umlenkwinkel

## Patentansprüche

1. Umlenkvorrichtung (2A-2D) für eine Flachbandleitung (4), insbesondere für einen Folienleiter, mit einer Grundklappe (10), mit einer eine Umlenkkante (24) aufweisenden Umlenkklappe (12) sowie mit einer Schutzklappe (14), die derart miteinander schwenkbar verbunden sind, dass im Montageendzustand bei eingelegter Flachbandleitung (4) zwischen der Grundklappe (10) und der Umlenkklappe (12) ein Führungsbereich (22) gebildet ist, in dem die Flachbandleitung (4) geführt ist und der sich bis zu einem zwischen der Umlenkkante (24) und der Schutzklappe (14) gebildeten Umlenkbereich (26) erstreckt, in dem die Flachbandleitung (4) umgelenkt ist.

2. Umlenkvorrichtung (2A-2D) nach Anspruch 1, bei der die Flachbandleitung (4) im Montageendzustand im Führungsbereich (22) und im Umlenkbereich (26) geklemmt ist.

3. Umlenkvorrichtung (2A-2D) nach Anspruch 1 oder 2, bei der die Umlenkkante (24) einen gerundeten Querschnitt aufweist.

4. Umlenkvorrichtung (2A-2D) nach einem der vorhergehenden Ansprüche, bei der die Umlenkklappe (12) und die Grundklappe (10) jeweils eine Flächenausdehnung mit zwei jeweils einander gegenüberliegenden Grundseiten (16A,B;18A,B) und Stirnseiten (16C,D; 18C,D) aufweisen, wobei die Grundklappe (10) und die Umlenkklappe (12) an einer ihrer Grundseiten (16A,18A) miteinander verbunden sind.

5. Umlenkvorrichtung (2A,2B) nach Anspruch 4 zur Querfaltung der Flachbandleitung (4), wobei an einer der Stirnseiten (18C) der Umlenkklappe (12) die Umlenkkante (24) vorgesehen ist, und wobei durch den zwischen einer der Grundseiten (16B,18B) und der Umlenkkante (24) eingeschlossenen Winkel (α) ein Umlenkwinkel (β) für die Flachbandleitung (4) festgelegt ist.

6. Umlenkvorrichtung (2A,2B) nach Anspruch 5, bei der die Schutzklappe (14) an der zur Umlenkkante (24) korrespondierenden Stirnseite (16C) der Grundklappe (10) angeordnet ist.

7. Umlenkvorrichtung (2C,2D) nach Anspruch 4 zur Längsfaltung der Flachbandleitung (4), wobei die Umlenkkante (24) an der der Grundklappe (10) abgewandten Grundseite (18B) der Umlenkklappe (12) angeordnet ist.

8. Umlenkvorrichtung (2C,2D) nach Anspruch 7, bei der die Schutzklappe (14) an der der Umlenkklappe (12) abgewandten Grundseite (16B) der Grundklappe (10) angeordnet ist.

9. Umlenkvorrichtung (2C,2D) nach Anspruch 7 oder 8, bei der im Montageendzustand zwischen der Schutzklappe (14) und der Umlenkklappe (12) ein weiterer Führungsbereich (53) für den Folienleiter (4) gebildet ist.

10. Umlenkvorrichtung (2D) nach einem der Ansprüche 7 bis 9 zur Längs- und Querfaltung der Flachbandleitung (4), wobei eine weitere Umlenkkante (62) für die Querfaltung vorgesehen ist, die insbesondere an der Schutzklappe (14) stirnseitig angeordnet ist.

11. Umlenkvorrichtung (2D) nach Anspruch 10, bei der eine weitere Schutzklappe (60) vorgesehen ist, die mit der weiteren Umlenkkante (62) zusammenwirkt, und hierzu insbesondere mit einer der Stirnseiten (18D) der Umlenkklappe (12) verbunden ist.

12. Umlenkvorrichtung (2A-2D) nach einem der vorhergehenden Ansprüche, bei der im Führungsbereich (22) ein Fixierelement (44,48) zum Fixieren der Flachbandleitung (4) vorgesehen ist.

13. Umlenkvorrichtung (2A-2D) nach einem der vorhergehenden Ansprüche, bei der an einer dem Führungsbereich (22) abgewandten Montageoberseite (32) ein Halteelement (34) für den umgebogenen Teil der Flachbandleitung (4) vorgesehen ist.

14. Umlenkvorrichtung (2A-2D) nach einem der vorhergehenden Ansprüche, bei der zumindest einige der einzelnen Klappen (10,12,14,60) im Montageendzustand miteinander fest verbunden, insbesondere miteinander verrastet sind.

15. Umlenkvorrichtung (2A-2D) nach einem der vorhergehenden Ansprüche, die zu ihrer Befestigung an einer Montageunterseite (36) ein Befestigungselement (38) aufweist.

16. Umlenkvorrichtung (2A-2D) nach einem der vorhergehenden Ansprüche, die eine Montageoberseite (32) mit einem Koppelelement (40) zur Anordnung einer weiteren Umlenkvorrichtung (2) aufweist.
